(19) Europäisches Patentamt
European Patent Office
Office européen des brevets

(11) **EP 4 748 633 A1**

(12) **EUROPEAN PATENT APPLICATION**

(43) Date of publication:
**27.05.2026 Bulletin 2026/22**

(21) Application number: **24214195.0**

(22) Date of filing: **20.11.2024**

(51) International Patent Classification (IPC):
**B60L 58/10** (2019.01)    **B60L 58/16** (2019.01)
**B60L 58/21** (2019.01)

(52) Cooperative Patent Classification (CPC):
**B60L 58/16; B60L 58/10; B60L 58/21;**
**G01R 31/385; H02J 7/52;** B60L 58/12;
B60L 2240/529; B60L 2240/545; B60L 2260/50

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Volvo Truck Corporation**
**405 08 Göteborg (SE)**

(72) Inventors:
• **ALTAF, Faisal**
**421 43 VÄSTRA FRÖLUNDA (SE)**
• **HALLBERG, Linus**
**423 73 SÄVE (SE)**

(74) Representative: **Kransell & Wennborg KB**
**P.O. Box 2096**
**403 12 Göteborg (SE)**

Remarks:
Amended claims in accordance with Rule 137(2)
EPC.

(54) **SITUATION-AWARE POWER-ABILITIES FOR A BATTERY ENERGY STORAGE SYSTEM**

(57)    A computer system (500) includes processing circuitry (510) configured to i) obtain an indication of a usage scenario and/or internal (and/or external) state of an entity, e.g. of an electric vehicle, including a battery energy storage system (ESS); ii) determine state-of-power, SoP, values for each of multiple battery packs of the ESS; iii) determine SoP values for the whole ESS by fusion of the SoP values for the battery packs determined in ii), and iv) determine a target SoP and control a charging/discharging of the ESS based on the target SoP value. The processing circuitry selects a particular set from a plurality of different sets of constraints corresponding to different trade-offs between entity performance and battery lifetime, based on the usage scenario and/or state, and uses this set as part of at least one of ii), iii) and iv). Each set of constraints includes a set of battery electro-thermal constraints.

Fig. 5

EP 4 748 633 A1

## Description

## TECHNICAL FIELD

The disclosure relates generally to battery energy storage systems (ESS/BESS), such as those used for electric vehicles or other power applications. In particular aspects, the disclosure relates to situation-aware power-abilities for such systems. The disclosure can be applied to heavy-duty vehicles, such as trucks, buses, and construction equipment, among other vehicle types, and also to e.g. a stationary BESS for industrial grid and residential power applications. Although the disclosure may be described with respect to a particular vehicle, the disclosure is not restricted to any particular vehicle.

## BACKGROUND

Battery energy storage systems (ESSs, or BESSs) and e.g. battery management systems (BMS) are commonly found in battery electric vehicles (BEVs) and fuel-cell electric vehicles (FCEVs). The ESS may for example be based on lithium-ion batteries, and is often both the most expensive and most safety-critical component of an electrified powertrain. The batteries may have complex non-linear dynamics and the BMS is often provided with advanced state/parameter estimations, predictions, and control algorithms, in order to ensure both optimal performance and long lifetime for the batteries. For commercial BEVs and FECVs, the ESS typically includes multiple larger battery packs connected in parallel, to meet high energy and power demands.

A main function of the ESS is to deliver/receive power and energy in a safe, robust and optimal way, preferably for multiple different vehicle applications and under varying operating conditions. To guarantee such functionality, the BMS is often configured to (in real-time) provide at least two sets of internal battery functions, including those relating to battery state/parameter estimation and diagnostics as well as those related to battery state control and safety. Battery state estimation may include estimation of internal electrochemical-thermal states of the batteries and their related components, and such estimates may in turn be used to provide predictions about power-ability (also referred to as state-of-power, SoP) and usable battery energy (also referred to as state-of-energy, SoE) during driving and/or charging of the vehicle. From an end-user perspective, SoP and SoE are two of the most important BMS functions as their accuracy often have a direct impact on vehicle performance, chargeability, drivability, retardation and range. Various controllers of the vehicle, such as a powertrain controller and vehicle controller, use SoP and SoE estimations for energy and power management. The functions related to battery state control and safety uses the results of the state estimation and diagnostics to control and optimize battery limits, such as temperature, state-of-charge (SoC), power, and similar to ensure safe, robust and optimal usage and operation. Consequently, both industry and academia have shown interest in further developing such functionalities, and there is ongoing efforts to e.g. design more intelligent BMSs for optimal utilization of battery cells, in order to guarantee their lifetime, performance and safety over their whole lifecycle.

Typically, the BMS is often provided with fixed control calibration values regarding the power-ability (SoP) of the ESS, for various predefined use-cases (such as for different driving cycles, usage patterns, operating conditions, etc.), performance targets (such as for different drivability, retardation braking, charging times, etc.), and total lifetime objectives. Phrased differently, the SoP functionality of the BMS is pre-calibrated in order to achieve a balancing between different attributes considering various pre-defined use-cases. After this calibration is completed, the powertrain controller must respect the communicated power-ability (SoP) limits from the BMS, and the vehicle usage is thus limited by the constraints imposed by the pre-calibrated and fixed SoP functionality of the BMS.

However, the vehicle usage patterns and power needs under real-world circumstances may be anything else than fixed, and are thus hard to pre-define. This is particularly true for commercial vehicles which often have a wide range of different usage patterns (e.g. for city buses, inter-city buses, medium-duty trucks, heavy-duty trucks, driving on flat roads, hilly roads, for construction equipment, marine applications, and similar). As a consequence, such pre-calibration SoP functionality are not likely to meet all requirements.

The present disclosure aims at improving on such conventional technology.

## SUMMARY

According to a first aspect of the disclosure, there is provided a computer system including processing circuitry. The processing circuitry is configured to i) obtain an indication of at least one of a) a current or predicted usage scenario and b) an internal and/or external state of an entity (such as e.g. an electric vehicle) including a (battery) energy storage system (ESS). The processing circuitry is configured to ii) determine one or more SoP values for each of a plurality of battery packs of the ESS. The processing circuitry is configured to iii) determine one or more SoP values for the ESS as a whole by fusion of at least some of the SoP values for the battery packs determined in ii). The processing circuitry is configured to iv) determine a target SoP value for control of a charging and/or discharging of the ESS based on the one or more SoP values determined in iii), and to control the charging and/or discharging of the ESS based on the determined target SoP value. The processing circuitry is further configured to select, from a plurality of different sets of constraints corresponding to different trade-offs between entity performance and battery lifetime, a particular set of constraints based on the indicated at least one of the current or predicted usage scenario and the internal and/or external state of the entity, and to use the particular set of constraints as part of the determining in at least one of ii), iii) and iv), wherein each set of constraints is or includes a set of battery electro-thermal constraints. The first aspect may seek to solve the problem of how to provide a more flexible SoP functionality. A technical benefit may include that by defining multiple sets of different performance-lifetime classes, the SoP functionality can adapt to a wider range of different use-cases and entity applications, and is not bound to any single set of predefined, pre-calibrated and thereby fixed constraints as in conventional solutions. Instead, situational awareness and/or knowledge about an internal and/or external state of the entity can be used to decide upon which of a plurality of different sets of constraints to use, and how e.g. values calculated for different battery packs and/or for different sets of constraints are fused together.

Optionally, in some examples, including in at least one preferred example, the entity is an electric vehicle.

Optionally, in some examples, including in at least one preferred example, the processing circuitry may be further configured to ii-a) as part of ii), determine at least one SoP value for each battery pack and for each of multiple sets of the constraints. The processing circuitry may be further configured to iii-a) as part of iii), determine at least one SoP value for the ESS as a whole for each of multiple sets of constraints. The processing circuitry may be further configured to iv-a) as part of iv), determine the target SoP value used to control the charging and/or discharging of the ESS by selecting a SoP value for the ESS as a whole determined as part of iii-a) and corresponding to the particular set of constraints. A technical benefit may include that the decision on what exact SoP value to use for the control of the charging/-discharging can be made further up in the hierarchy, e.g. by a power control unit (PCU), a vehicle control module (VCM) (in case the entity is the electric vehicle), or similar, based on situational awareness and/or knowledge about the internal entity state of such higher-level modules.

Optionally, in some examples, including in at least one preferred example, the processing circuitry may be further configured to ii-a) as part of ii), determine the at least one SoP value for each battery pack based on the particular set of constraints. A technical benefit may include that decisions based on situational awareness and/or knowledge of the internal and/or external state of the entity can thus be made at a lower-level of the overall hierarchy, e.g. by the BMS itself, e.g. by a battery management function (BMF) and/or battery management unit (BMU), or similar, as long as these lower-level modules are made situational aware and/or knowledgeable about the internal and/or external state of the entity. Higher-level modules, such as the PCU and/or VCM may thus receive only a target SoP wherein how to e.g. fuse SoP values for different sets of constraints has already been decided further up in the hierarchy, and similar.

Optionally, in some examples, including in at least one preferred example, the determination in iii) and iv) may not include determining SoP values for multiple sets of constraints (and instead to determine such SoP values only for a reduced set of constraints, e.g. one for each battery pack). A technical benefit may include that the number of calculations performed can thus be reduced, such that the situational awareness and/or knowledge about the internal and/or external state of the entity is used to directly determine the SoP values for e.g. each of the plurality of battery packs, for the SoP of the ESS as a whole, or similar.

Optionally, in some examples, including in at least one preferred example, each of ii) and iii) may include determining the SoP values for each of a plurality of different time horizons. Here, "SoP values" may be those for each battery pack and/or those for the ESS as a whole, and the target SoP value may be selected based also on a preferred such time horizon.

Optionally, in some examples, including in at least one preferred example, the battery electro-thermal constraints may include constraints on at least battery temperature and voltage. A technical benefit may include that battery temperature and voltage may be two of the most important parameters of a battery in terms of battery lifetime and safety, as exceeding e.g. a certain temperature and/or voltage may otherwise damage the battery (pack, and e.g. cells of the pack).

Optionally, in some examples, including in at least one preferred example, the battery electro-thermal constraints may include constraints on at least battery current as a function of battery SoC, temperature and state-of-health (SoH). A technical benefit may include that it may be taken into account that properties of the battery often change with SoC, temperature and SoH, and may for example be different for newer and older batteries, for colder and hotter batteries, for more fully charged and more depleted batteries, and similar.

Optionally, in some examples, including in at least one preferred example, the battery electro-thermal constraints may include constraints on at least one of an absolute max power constraint, a root-mean-square (RMS) power constraint for a battery lifetime, and an allowed battery over-utilization budget. A technical benefit may include that such constraints can bring usage-history awareness into the SoP prediction, e.g. such that a lifetime of the battery may be "protected" by derating its power-ability and hence avoid e.g. continuous peak power performance, and by e.g. avoiding the battery keeping delivering peak performance considering only its instantaneous states and current gap from electro-thermal limits (such as voltage, temperature, etc.).

Optionally, in some examples, including in at least one preferred example, the computer system (e.g. the processing circuitry) may be further configured to obtain the indication of the at least one of the current or predicted usage scenario and the internal and/or external state of the entity (such as the electric vehicle) based on at least one of: a historical usage pattern and power demand for the entity; an instantaneous power demand defined by a user of the entity; a pre-planned mission/assignment of the entity, and real-time detection of power-demand for the entity.

Optionally, in some examples, including in at least one preferred example, the processing circuitry may be configured to perform the fusion in ii) based on the at least one of the current or predicted usage scenario and the internal and/or external state of the entity.

Optionally, in some examples, including in at least one preferred example, the internal and/or external state of the entity may include at least one of a battery SoH and a state of one or more other components of the entity, such as for example brake health (if the entity is the electric vehicle). A technical benefit may include that e.g. an indicated low brake health may be compensated for by providing more regenerative braking, or similar, especially if the SoH of the battery is good. Other such information may include that from a thermal management system (TMS), which can be used to e.g. derate ESS power-ability if it is known that the TMS will (e.g. due to a reduced capability, a fault or by prioritization) not be able to keep the battery temperature within desired limits. Likewise, knowledge about e.g. SoH of individual battery packs can be used to decide to fuse power-abilities (i.e. SoP values) accordingly, e.g. by mixing power-abilities considering mixing of batteries with different SoH levels.

According to a second aspect of the disclosure, there is provided an electric vehicle (such as a BEV, FCEV, or similar). The vehicle includes the computer system of the first aspect (or any example thereof) and the ESS including the plurality of battery packs. The second aspect may seek to solve a similar problem as that solved by the computer system of the first aspect, namely, how to provide a vehicle with the improvements following from the improved computer system.

According to a third aspect of the disclosure, there is provided a computer-implemented method. The method includes i) obtaining, by processing circuitry of a computer system (such as that of the first aspect) an indication of at least one of a) a current or predicted usage scenario and b) an internal and/or external state of an entity (such as e.g. an electric vehicle) including a battery energy storage system (ESS). The method includes ii) determining, by the processing circuitry, one or more SoP values for each of a plurality of battery packs of the ESS. The method includes iii) determining, by the processing circuitry, one or more SoP values for the ESS as a whole by fusion of at least some of the SoP values for the battery packs determined in ii). The method includes iv) determining, by the processing circuitry, a target SoP value for control of a charging and/or discharging of the ESS based on the one or more SoP values determined in iii), and to control the charging and/or discharging of the ESS based on the determined target SoP value. The method further includes selecting, by e.g. the processing circuitry, from a plurality of different sets of constraints corresponding to different trade-offs between entity performance and battery lifetime, a particular set of constraints based on the indicated at least one of the current or predicted usage scenario and the internal and/or external state of the entity, and to use the particular set of constraints as part of the determining in at least one of ii), iii) and iv), wherein each set of constraints is or includes a set of battery electro-thermal constraints. The method of the third aspect may seek to solve a similar problem as the computer system of the first aspect, namely, how to provide a method for obtaining the same advantages.

According to a fourth aspect of the disclosure, there is provided a computer program product including program code for performing, when executed by the processing circuitry, the method of the third aspect.

According to a fifth aspect of the disclosure, there is provided a computer-readable storage medium including instructions, which, when executed by the processing circuitry, cause the processing circuitry to perform the method of the third aspect. The computer-readable storage medium may be non-transitory.

According to a sixth aspect of the disclosure, there is provided an entity for energy storage (such as an industrial and/or residential energy storage solution, e.g. a battery bank), comprising the computer system of the first aspect and the ESS.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits

## BRIEF DESCRIPTION OF THE DRAWINGS

Examples are described in more detail below with reference to the appended drawings.

**FIG. 1** schematically illustrates an example propulsion control system of an electric vehicle, according to one or more examples.
**FIG. 2** schematically illustrates various examples of sets of battery electro-thermal constraints, according to one or more examples.
**FIG. 3** schematically illustrates an example interplay between BMS and vehicle ECU, according to an example.
**FIG. 4** schematically illustrates another example interplay between BMS and vehicle ECU, according to an example.

**FIG. 5** schematically illustrates various examples of a computer system, according to one or more examples.

**FIG. 6** schematically illustrates various examples of a computer-implemented method, according to one or more examples.

**FIG. 7A** schematically illustrates an example vehicle, according to an example.

**FIG. 7B** schematically illustrates an example stationary BESS solution, according to an example.

**FIG. 8** is a schematic diagram of an example computer system for implementing examples disclosed herein, according to an example.

## DETAILED DESCRIPTION

The detailed description set forth below provides information and examples of the disclosed technology with sufficient detail to enable those skilled in the art to practice the disclosure.

The present disclosure applies generally to all forms of entities that include one or more (battery) ESSs. However, in what follows, an electric vehicle will mainly be used to illustrate an example such entity.

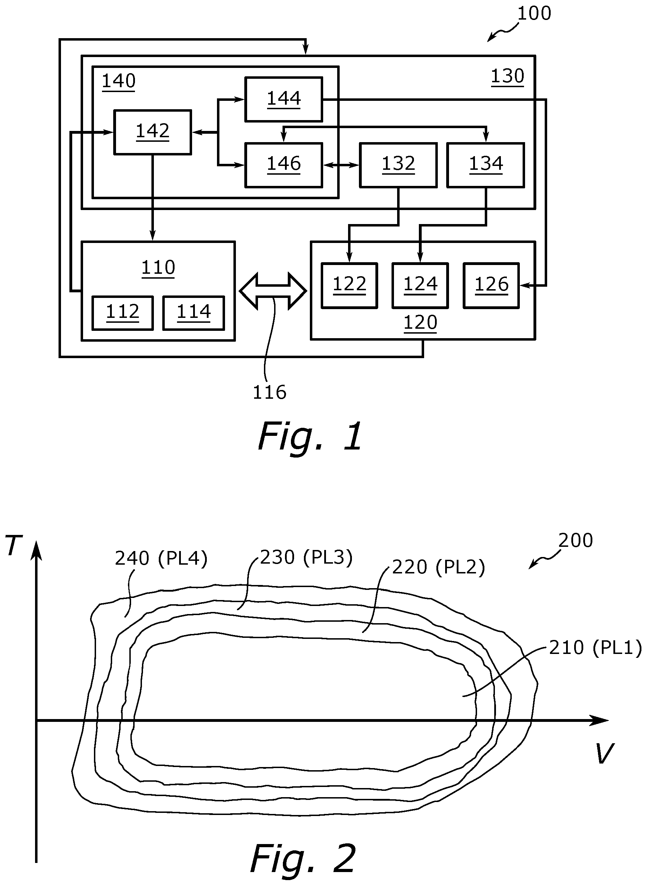

**FIG. 1** schematically illustrates an example propulsion control system (PCS) 100, exemplifying various interfaces between the ESS 110, various electronic propulsion system (ECS) controllers 130 and various loads 120 of the vehicle, such as one or more electrical machines (EM) 122, one or more gearboxes 124 and one or more auxiliary electrical systems 126. As envisaged herein, the box 120 may also represent one or more sources, such as a charging system or similar capable of providing power to charge the battery packs of the ESS 110.

The ESS 110 includes a plurality of battery packs, and provides various functionality such as a battery management functionality (BMF) 112 and/or a multi-battery ESS management functionality (ESSMF) 114. There may e.g. be one BMF 112 provided for each battery pack in the ESS 110, or one or more BMFs 112 may be responsible for more than one battery pack. As will be described in more detail later herein, the BMF(s) 112 can in turn communicate with the ESSMF 114, where the latter is responsible for providing functionality related to the ESS 110 as a whole (e.g. multi-battery pack ESS management functionality). The goal of the ESS 110 is to provide and/or receive power 116 to/from the various loads 120, e.g. to power the EM 122 and/or to receive power from one or more charging devices (such as an internal or external charger).

The EPS controllers 130 includes a propulsion control unit (PCU) 140 configured to manage a conversion of electrical energy for various uses within the vehicle. The PCU 140 may for example be configured manage the conversion of electrical energy by controlling various kinds of power converters or indirectly through one or more other control units (such as motor control units), e.g. power generated by a motor/generator (such as EM 122) and/or received from a charging device for use in charging of the vehicle's ESS. Likewise, the PCU 140 may be configured to manage energy conversion to e.g. store energy in the ESS 110 such that it may be used to drive the one or more EMs 122 of the vehicle.

The PCU 140 includes an ESS interface 142 through which it communicates with the ESS 110. The interface 142 may of course also instead be provided as part of the ESS 110, and/or as a collection of interfaces provided by both the ESS 110 and the PCU 140. The PCU 140 further includes an electric system management (ESM) functionality 144 responsible for e.g. controlling/-managing the auxiliary loads 126, and a propulsion system management (PSM) functionality 146 responsible for controlling/managing e.g. the EM(s) 122 and gearbox(es) 124. This may be achieved by the PSM 146 communicating with a motor control unit (MCU) 132 and/or a transmission electronic control unit (TECU) 134, or similarly, i.e. such that the PSM 146 communicates either directly or indirectly with e.g. the EM(s) 122 and/or gearbox(es) 124. As indicated by the arrows, there may of course also be other communications taking place, such as between the loads 120 and one or more of the EPS controllers 130 other than the MCU 132 and/or TECU 134. One or more additional units/functional blocks may of course also be included, such as for example a charger, charging management functionality, and similar, as described earlier herein.

In conventional solutions, the ESS 110 communicates (via e.g. its various BMUs) a single SoP value $SoP_i$ for each battery pack, where $i \in [1, M]$ is an integer indicating the $i$:th such battery pack out of $M$ battery packs in total. In some conventional solutions, there may be different SoP values for charging and discharging, e.g. $SoP_i^{cha}$ and $SoP_i^{dch}$ for charging and discharging, respectively. If multiple time horizons are considered, there may be one such SoP value for each battery pack and time horizon, e.g.

$$SoP_i^{cha/dch} = \begin{bmatrix} SoP_i^{cha/dch,Short} \\ SoP_i^{cha/dch,Medium} \\ SoP_i^{cha/dch,Long1} \\ \vdots \\ SoP_i^{cha/dch,Long\Lambda} \\ SoP_i^{cha/dch,Continuous} \end{bmatrix},$$

where the superscripts *Short*, *Medium*, *Long1*, ..., *Long*Λ denote a set different time horizons (with Λ denoting a total number of such longer time horizons), respectively, and where "*Continuous*" corresponds to continuous operation. In general, such conventional solutions uses a same single pre-defined set of battery electro-thermal constraints for defining these power-ability SoP values. The various modules/functionalities of the EPS controllers 130, such as the ESM 144, the PSM 146, MCU 132 and/or TECU 134 are then bound to respect the SoP values communicated by the ESS 110, and as a single set of pre-defined constraints is used, the resulting control and operation of the ESS 110 is likely to be sub-optimal as such a single pre-defined set of constraints cannot take into account the vast variety of different use-cases and vehicle applications (or e.g. stationary BESS applications) that exist.

How the present disclosure aims at overcoming at least some of these limitations of contemporary technology will now be described in more detail with reference also to FIGS. 2, 3, 4, 5, 6, 7 and 8.

**FIG. 2** schematically illustrates how the present disclosure proposes to introduce a plurality of different sets of electro-thermal constraints, each corresponding to a different trade-off between vehicle performance and battery lifetime. In an example plot 200, FIG. 2 illustrates constraints of voltage and temperature. It is however to be noted that the present disclosure is not limited only to constraints on voltage and temperature, and that there may be one or more additional (or other) battery electro-thermal parameters that are constrained, instead of or in addition to those of voltage and temperature as shown in FIG. 2. For example, there may be constraints on battery current as a function of SoC, temperature and SoH. As another example, constraints may also be imposed on e.g. absolute max power, RMS power, an allowed battery over-utilization budget, and similar. In summary, although illustrated in FIG. 2 as two-dimensional constraints on voltage and temperature, the envisaged constraints may be n-dimensional (where $n > 2$).

In the example of FIG. 2, it is envisaged herein to define a set of different performance levels, including e.g. low performance (P1), moderate performance (P2), high performance (P3) and maximum/extreme performance (P4), where each performance level corresponds to a resulting usage of the battery, i.e. low/mild usage (for P1), moderate usage (for P2), high usage (for P3) and harsh usage (for P4). Each performance level may be defined with respect to power-ability as an optimization variable.

Classification of usage may for example be done in a statistical (i.e. probabilistic) sense, instead of specifying a single deterministic drive cycle for each use case. The statistical representation may provide a multi-dimensional usage histogram (or probability density function, PDF) capturing the level of battery utilization (frequency or time spent) with respect to various stress factors such as current, voltage, temperature, and similar.

Likewise, it is envisaged to also define a set of different expected battery lifetimes (i.e. lifetime levels), such as e.g. longest lifetime (L1), moderate lifetime (L2), reduced lifetime (L3) and short(est) lifetime (L4). From such different performance and lifetime levels, it is envisaged to define multiple sets of battery electro-thermal constraints, e.g. a first set PL1 corresponding to low performance and mild usage (and the longest lifetime, i.e. to P1 and L1), a second set PL2 corresponding to moderate performance and usage (and moderate lifetime, i.e. to P2 and L2), a third set PL3 corresponding to high performance and usage (and to reduced lifetime, i.e. to P3 and L3), and a fourth set PL4 corresponding to extreme/maximum performance and harsh usage (and to short(est) lifetime, i.e. to P4 and L4). Phrased differently, it is envisaged to define multiple performance-lifetime classes, by mapping of performance levels to lifetime levels. Such mapping may for example be performed after using simulation-based verification (based on various aging and performance models) and experimental characterization of lifetime under at least one representative use-case for each performance and usage class.

Each such performance-lifetime class *PLn* (with $n = 1,2,3, ..., N$, where $N$ is the total number of such classes/sets) thus corresponds to a set of constraints on (in this example) voltage and temperature as indicated in FIG. 2, i.e. a first set 210 for PL1, a second set 220 for PL2, a third set 230 for PL3, and a fourth set 240 for PL4, and so on depending on how many sets of constraints (i.e. how many performance-lifetime classes) there are. The exact shape of each set 210, 220, 230 and 240 is of course only for illustrative purposes of the envisaged concept, and is here not shown according to real values, scale and/or shape. For example, if e.g. the limitations on voltage do not depend on temperature (and vice versa), each set could for example be defined as a rectangle, defined by $V \in [V_{low}^i, V_{high}^i]$ and $T \in [T_{low}^n, T_{high}^n]$ where $V_{low/high}^n$ and $T_{low/high}^n$ is the low and high temperature and voltage limits, respectively, for the *n*:th performance-lifetime class *PLn*. In other examples, such as illustrated in FIG. 2, the voltage limitations/constraints may e.g. depend on temperature (and vice versa), resulting in the non-rectangular areas of the sets 210, 220, 230, 240. As envisaged herein, based on this multi-dimensional classification, multiple sets of control calibrations (current, voltage, temperature, etc.) for the SoP functionality are thus derived, e.g. four different sets of calibrations/constraints as shown in FIG 2., i.e. one for each practically relevant combination of performance and lifetime levels/classes as described earlier herein. Consequently, the SoP functionality has the flexibility to select one of these calibrations/constraint sets at a given time point, considering the current application, or e.g. to use multiple or all of them simultaneously to predict multiple types of ESS power-abilities as independent signals.

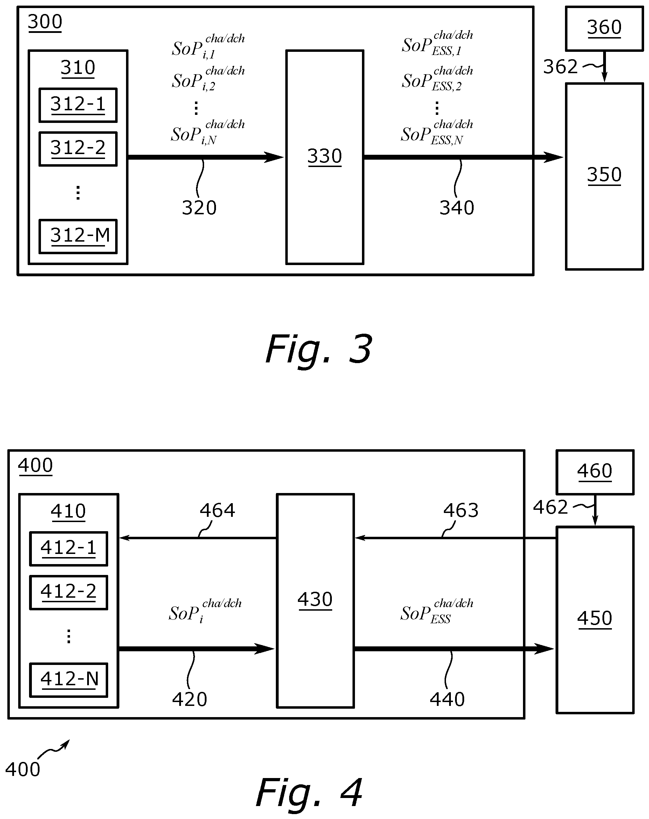

FIG. 3 schematically illustrates one particular example of interplay between BMS 300 and vehicle ECU 350 as envisaged herein. In this example, the BMS 300 calculates (using e.g. a BMF 310) SoP values for each battery pack of the ESS and for each set of a plurality of different sets of battery electro-thermal constraints. For example, each of a BMU 312-1 responsible for battery pack 1, a BMU 312-2 responsible for battery pack 2, ..., and a BMU 312-M responsible for battery pack M, calculates a set of SoP values $SoP_{i,n}^{cha/dch}$, where $i \in [1, M]$ and $M$ is the total number of battery packs, and where $n \in [1, N]$ and $N$ is the total number of different sets of constraints. Thus, for each $n$:th performance-lifetime class PLn, there is calculated (by e.g. a corresponding BMU 312-i) a corresponding power-ability value $SoP_{i,n}^{cha/dhc}$ for each $i$:th battery pack. For $M$ battery packs and $N$ performance-lifetime classes, the BMF 310 is thus responsible for calculating at least $M \times N$ SoP values. If different SoP values are provided for both charging and discharging, the total number is multiplied by two. Although not illustrated in this example, as envisaged herein, the BMF 310 may also provide such SoP values for each of a plurality of different time horizons. For example, the BMF 310 may provide at least SoP values $SoP_{i,n,k}$, where $i \in [1, M]$, $n \in [1, N]$ and $k \in [1, K]$ where $K$ is the total number of different time horizons, such as $S$, $M$, $L1$, ... $L\Lambda$, $C$, etc., as exemplified earlier herein. Of course, also in this case, different SoP values may also be calculated for both charging and discharging, thus resulting in a total of $2 \times M \times N \times K$ SoP values provided by the BMF 310. The BMF 310 may of course use a same BMU to calculate such values for more than one battery pack, such as for two, or more, including e.g. all, battery packs, or similar, or the BMF 310 may provide the required SoP values by other means.

As generally used herein, the term "SoP" (or "power ability") may be considered as a power-gauge of a battery, battery pack or ESS that serves as an indicator of maximum pulse power capability for a predefined time period (such as e.g. a few seconds, minutes, or similar), wherein this pulse power capability does not violate any electro-thermal limits and ageing/lifetime constraints. As it is envisaged to define multiple sets of such constraints, multiple SoP values may thus be calculated for each battery, battery pack or ESS, i.e. at least one SoP value for each set of constraints.

The calculated (or determined) SoP values for each of the plurality of battery packs are provided as part of e.g. a signal/output 320 that is provided to/shared with an ESSMF 330. The ESSMF 330 is configured to fuse at least some of the SoP values for the battery packs, to determine one or more SoP values for the ESS as a whole. For example, the ESSMF 330 may calculate/determine one SoP value for each set of constraints, e.g. $SoP_{ESS,n}$ where ESS indicates that these SoP values are for the ESS as a whole, and where $n \in [1, N]$. Also here, the ESSMF 330 may also calculate such values both for charging and discharging, i.e. $SoP_{ESS,n}^{cha/dch}$, and/or for different time horizons, e.g. $SoP_{ESS,n,k}^{cha/dch}$. As envisaged herein, the set of time horizons for which the ESSMF 330 is (optionally) configured to output SoP values for may not necessarily be the same as those considered by e.g. the BMF 310, e.g. the time horizons considered by the ESSMF 330 in its output may be fewer, more and/or different than those considered by the BMF 310. The calculated (or determined) SoP values for the ESS as a whole are provided as part of e.g. a signal/output 340 that is provided to/shared with the vehicle ECU 350.

In some examples, the ESSMF 330 may be configured to also mix/fuse SoP values of battery packs according to different performance-lifetime classes. For example, a SoP value for e.g. a first battery pack for a first performance-lifetime class may be mixed/fused with a SoP value for e.g. a second battery pack for a second performance-lifetime class, i.e. such that the SoP value $SoP_{ESS,j}$ for the ESS as a whole (for a performance-lifetime class $j$) may depend on SoP values for battery packs associated with different performance-lifetime classes, and not necessarily only on SoP values for a same performance-lifetime class. Phrased differently, as envisaged herein, the SoP value $SoP_{ESS,j}$ may depend on values $SoP_{i,j'}$, where $j' \neq j$, i.e. the ESSMF 330 may mix and match SoP values for different battery packs but also for different performance-lifetime classes, depending on the indicated situation and/or internal and/or external state.

The vehicle ECU 350 may e.g. be, or include, one or more of a PCU and VCM, and is in this example made situational aware of a current or predicted usage scenario of the vehicle, and/or of at least one internal and/or external state of the vehicle. This for example by receiving one or more signals 362 from a situational awareness and/or state knowledge module 360. The one or more signals 362 may include an indication of the usage scenario and/or internal and/or external state, or e.g. including or one or more other parameters from which the ECU 350 can itself determine the usage scenario and/or internal and/or external state. Based on this information, the ECU 350 then decides which of the many SoP values 340 for the ESS as a whole output from the ESSMF 330 that is to be used as a target SoP value for controlling a charging and/or discharging of the ESS.

FIG. 4 schematically illustrates another particular example of interplay between a BMS 400 and vehicle ECU 450 as envisaged herein. In this example, the ECU 450 does not decide/select the relevant SoP values based on situational awareness and/or knowledge about the internal and/or external state of the vehicle. Instead, the BMS 400 (via e.g. a BMF 410 and ESSMF 430) is made situational aware and/or knowledgeable about the internal and/or external state of the vehicle, by receiving e.g. information from a situational awareness and/or knowledge module 460, in form of e.g. one or more signals either directly from the module 460 or propagated via the ECU 450 and on to the ESSMF 430 and the BMF 410, via corresponding signals 462, 463 and 464, respectively. Phrased differently, in this example, the higher-level ECU 450 may not be responsible decide among multiple classes of available power-abilities for different performance-lifetime classes, but instead relies on the lower-level components such as the BMS 400, ESSMF 430 and/or BMF 410 to make such decisions.

For example, the BMF 410 (using e.g. one or more of BMUs 412-1, 412-2, ..., 412-N), may be configured to calculate/determine a single SoP value for each battery pack, i.e. $SoP_i$ or $SoP_i^{cha/dch}$, based on e.g. a situational battery pack power demand indicated by the signal 464. This may include e.g. the BMF 410 first calculating all $SoP_{i,n}$ (or $SoP_{i,n}^{cha/dch}$) and then selecting which performance-lifetime class $n$ to use for each battery pack $i$, or e.g. by the BMF 410 being configured to directly (based on the signal 464) determining which SoP value to calculate without first calculating SoP values for all classes $n$ (that is, in this example, the BMS 400 is not required to calculate SoP values for each battery pack for each performance-lifetime class, but may instead calculate only a reduced number of SoP values wherein the relevant performance-lifetime class is selected based on the situational awareness and/or knowledge about the internal and/or external state of the vehicle)s. As before, SoP values may still also be calculated for each of a plurality of different time horizons, i.e. the BMF 310 may output, as part of a signal 420, $SoP_i$, $SoP_i^{cha/dch}$, $SoP_{i,k}^{cha/dch}$, $SoP_{i,k}$, or similar.

The BMS 400 is further configured, using the ESSMF 430, to fuse the SoP values 420 for the plurality of battery packs of the ESS into one or more (such as e.g. one) SoP value for the ESS as a whole, e.g. to obtain a value $SoP_{ESS}^{cha/dch}$ based on the SoP values 420. How to fuse the various values may for example be determined based on a situational ESS power demand communicated (or derivable from) the signal 463. After having calculated the one or more SoP values for the ESS as a whole (such as $SoP_{ESS}^{cha/dch}$), these values are provided as part of a signal 440 to the vehicle ECU 450, which may then use this SoP value directly as a target SoP value for controlling the discharging and/or charging of the ESS, without itself needing to be situational aware and/or knowledgeable about the internal and/or external state of the vehicle.

The examples of FIGS. 3 and 4 show to illustrate that as envisaged herein, either the vehicle ECU or the BMS, or even a combination of both, may be situational aware and/or knowledgeable of the internal and/or external state of the vehicle. In the example of FIG. 3, the BMS 300 was not situational aware and calculated SoP values for each battery pack and for each performance-lifetime class, and then fused these values together (using the ESSMF 330) to create a SoP value for the ESS as a whole for each performance-lifetime class, such that the situational aware vehicle ECU 350 can decide which of the values to use as the target SoP value. In the example of FIG. 4, it was instead the BMS 400 that was situational aware and/or knowledgeable of the internal and/or external state of the vehicle, such that it could take into account what performance-lifetime class to consider and output the target SoP value to the vehicle ECU 450, such that the latter need not be e.g. situation aware. However, independent of which particular solution that is used, there is defined a plurality of different sets of constraints corresponding to different performance-lifetime classes, and a decision is made (either in the BMS or by the vehicle ECU) what performance-lifetime class or classes to consider based on a current or predicted usage scenario and/or internal and/or external state of the vehicle, which allows for an improved flexibility and possibility to adapt to various different driving scenarios and use-cases for the vehicle, without being limited to only a single set of predefined calibration constraints that may not be well suitable for optimal performance and/or lifetime in all conditions and situations. In addition, what particular performance-lifetime classes (i.e. set of battery pack constraints) to use may be decided not only based on historical information, but also on future vehicle mission information, such that the performance-lifetime classes to consider (for e.g. each battery pack) may change with time.

Although illustrated as various functional modules (such as the BMS, BMF, BMU, ESSMF, vehicle ECU, etc.) in example FIGS. 3 and 4, the envisaged solution is not dependent on exactly what calculations that are performed in exactly what different functional modules. Instead, it will herein be referred to a "computer system" that may be e.g. a single computer system, a set of multiple computer systems (such as a distributed computer system), and which may be implemented using any particular configuration of functional modules. For example, the BMF such as 310 and 410 may not necessarily be implemented by a same physical device as e.g. the ESSMF 330 or 430, and similar, depending on whether it is preferred to use a centralized or distributed setup.

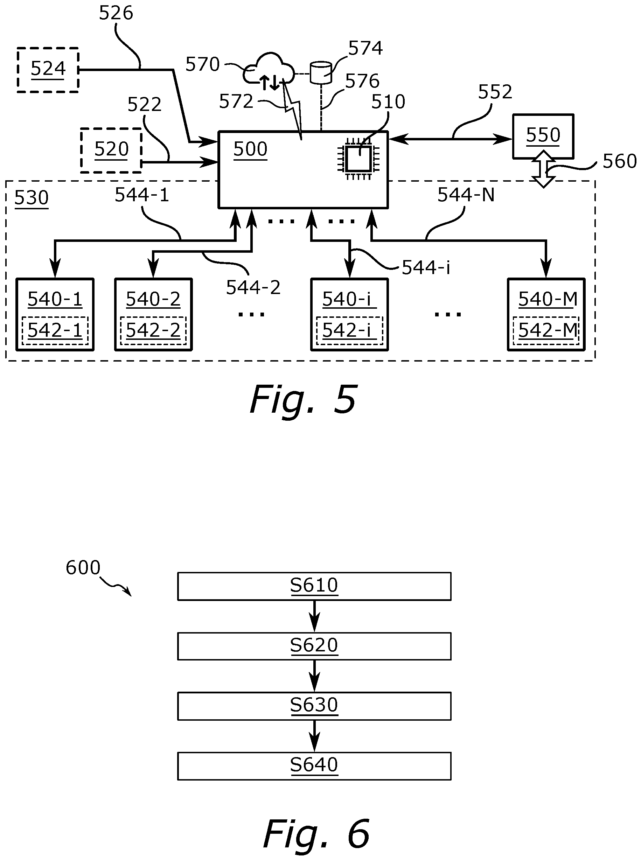

**FIG. 5** schematically illustrates examples of such a computer system 500, that includes processing circuitry 510.

**FIG. 6** schematically illustrates examples of a computer-implemented method 600, including various operations as performed by the processing circuitry 510 of the computer system 500.

As mentioned above, although illustrated as a single processing circuitry 510, the processing circuitry 510 may be representative of one, two or many processors or similar that may be found in one, two or many different functional modules/device that may or may not also be physically separated.

The processing circuitry 510 is configured to obtain (e.g. as part of an operation S610 of the method 600) an indication of the at least one of the current or predicted usage scenario and the internal and/or external state of the entity (e.g. electric vehicle). As envisaged herein, a usage scenario may correspond to a particular power-requirement, e.g. an indication that the vehicle (e.g. one or more loads 550, such as one or more electrical machines) will soon or currently require a particular amount of power 560 from an ESS 530, and/or to provide a particular amount of power 560 to the ESS 530. Such situational awareness may for example be obtained based on historical logged vehicle data (such as mission data), stored in e.g. a storage 574 and/or cloud-based service 570 to which the processing circuitry 510 has access by one or more wireless 572 and/or wired 576 connections. Such awareness may also, or in addition, e.g. be provided based on input 522 from a user-interface 520 (provided e.g. within a cabin of the vehicle, or similar), and/or from a situational awareness (and/or knowledge) module 524 via input 526. Such a module 524 may for example be a separate module responsible for determining the current or predicted usage scenario, and may use e.g. data found in storage 574 and/or service 570 for such purposes, communicate with the user interface 520, and/or with one or more other sensors (such as weather sensors and/or services, cameras, or similar) in order to determine the current or predicted usage scenario. For example, a user of the vehicle (such as a driver, control planner, or similar) may indicate a particular usage scenario by e.g. clicking a corresponding button, selecting from a menu, or similar, e.g. on a user display panel (e.g. touch screen) provided at the user. The user selection may thus indicate e.g. an instantaneous power demand, corresponding to e.g. a desire to use low, moderate, high or maximum power, or similar. In other examples, instead or in addition, situational awareness may be based on predictive vehicle control strategies, wherein e.g. topological map data, weather conditions, a loading of the vehicle, etc., care used to predict upcoming power requirements and similar. Yet other examples include to use e.g. pre-planned entity/vehicle missions/assignments (route-planning) and/or estimations based on real-time detection of power demand in a given situation/event, e.g. as even-triggered estimation.

As also envisaged herein, instead or in addition to a predicted or current usage scenario, the processing circuitry 510 may receive an indication about one or more internal and/or external states of the vehicle, such as one or more internal battery states (such as temperature, SoH, SoC, etc., of the battery packs/ESS), and/or one or more internal and/or external states of other vehicle components such as e.g. brakes (are the brakes worn, overheated, malfunctioning, etc.), transmission, wheels, and similar, of the vehicle.

A data-driven approach may be used to classify an historical usage of the ESS, such as described in e.g. EP 4299367 A1 and EP 4390793 A1 by the same applicant, documents that are in their entirety incorporated herein by reference. For example, logged vehicle data (LVD) may be used to present histograms showing e.g. time spent under various operating conditions (such as temperature current, voltage, SoC windows). From such histograms, maximum performance requirements (in terms of e.g. power-ability and useable energy) may be determined for a given vehicle, and the power-ability requirements may be further refined in terms of e.g. instantaneous peak and short pulse power demand (for e.g. gear shifting), medium and long duration pulses along with frequency of occurrence (for e.g. over-taking maneuvers), very long power pulses (for e.g. long retardation-braking episodes downhill), as well as for e.g. continuous power-demand (for constant-speed driving on e.g. highways). Other parameters such that e.g. charging time and charging power requirements may also be estimated based on such data. Current and future mission awareness may for example be implemented based on e.g. historical LVD or based on input regarding vehicle mission scheduling from e.g. a fleet operator. For example, if information that is received indicates that a mission is to be driven on flat terrain, a less aggressive (such as e.g. PL1) performance-lifetime class can be used. Likewise, if the information received e.g. from the fleet operator indicates that the mission is to be driven on predominantly hilly terrain, a more aggressive performance-lifetime class (such as e.g. PL3) may be considered instead. Consequently, the envisaged solution enables to "recalibrate" the SoP values based on the assumed mission type and requirements, and it may be switched between different performance-lifetime classes (and thereby between different SoP values for different performance-lifetime classes) also based on future mission information, e.g. to perform future situation aware selection of what performance-lifetime class (e.g. what set of constraints) to use. As yet another example, predictive information from e.g. lookahead topographical data (such as used by Volvo's I-See functionality) may also be used to implement the situation awareness. For example, such technology may be used to determine for example that an upcoming hill may require more power according to the vehicle's total weight and cargo. The BMS may then for example provide a SoP value based on higher performance-lifetime classes to enable such an uphill maneuver. Similarly, lookahead data may be used to determine that an upcoming downhill section of the road is imminent, and if combined with information about an internal and/or external state of the vehicle such as brake health status, higher performance-lifetime classes may be used to enable e.g. more regenerative braking in order to offload some of the burden of the normal brakes (e.g. to reduce brake wear in general). If the internal and/or external state indicates that e.g. the brakes are damaged, a highest performance-lifetime class (such as PL4) may be used to ensure safety of the vehicle, i.e. to enable maximum regenerative braking. Other possible ways of obtaining and using situational awareness and/or knowledge about at least one internal and/or external state of the vehicle to decide how to select, mix and/or match SoP values for different performance-lifetime classes are of course also possible.

The processing circuitry 510 is configured to determine (e.g. as part of an operation S620 of the method 600) the one or more SoP values for each of a plurality of battery packs 540-1, 540-2, ..., 540-M (herein also collectively referred to as battery packs 540) of an ESS 530. For example, this may be achieved by the processing circuitry 510 being configured to communicate (via signals 544-1, 544-2, ..., 544-M, herein also collectively referred to as signals 544) with for example corresponding BMUs 542-1, 542-2, ..., 542-4 (herein also collectively referred to as BMUs 542). The BMUs 542 may for example be implemented separately from the computer system 500 and processing circuitry 510, or the processing circuitry 510 may be used to implement one, more or all of the BMUs 542.

The processing circuitry 510 is further configured to determine (e.g. as part of an operation S630 of the method 600) the one or more SoP values for the ESS as a whole, by fusion of at least some of the SoP values for the battery packs determined as part of e.g. operation S620. For example, if the at least one state of the vehicle is a brake status, and if the brake status indicates that e.g. a state of the brakes is not good, then this fusion may include to select the more aggressive SoP values (e.g. corresponding to more aggressive performance-lifetime classes allowing for more performance and more battery wear), in order to e.g. offload some of the burden on the brakes by instead providing more generative braking, to reduce over-heating and/or complete failure of the brakes. As another example, such fusion may include to consider SoH of the battery packs, and to select more aggressive SoP values for battery packs that has greater SoH (due to e.g. being newer), which may for example improve the overall performance of the ESS/vehicle, and e.g. allow such newer battery packs to catch up with the older ones in terms of remaining lifetime and SoH.

The processing circuitry 510 is further configured to determine (e.g. as part of an operation S640 of the method 600) the target SoP value for control of the charging and/or discharging of the ESS 530, based on the one or more SoP values determined as part of e.g. operation S630. For example, the processing circuitry 510 may be configured to provide suitable one or more control signals 552 to directly (or indirectly) control the various loads 550 of the vehicle (such as the EMs), such that the power exchange 560 between the loads 550 and ESS 530 respects the target SoP value. To decide which target SoP to use, the processing circuitry 510 may in some examples be configured to rely also on the information about the current or predicted usage scenario and/or the at least one internal and/or external state of the vehicle, e.g. such information can be used, as envisaged herein, in any component/module responsible for fusing and/or selecting SoP values based on such information.

In particular, the processing circuitry 510 is further configured to select, from the plurality of different sets of constraints corresponding to the different trade-offs between vehicle performance and lifetime (i.e. from the different performance-lifetime classes *PLn*), the particular set of constraints based on the indicated at least one of the current or predicted usage scenario and the internal and/or external state of the vehicle, and to use the particular set of constraints as part of the determining performed in at least one of e.g. operations S620, S630 and S640 as described above. As mentioned earlier herein, each set of constraints is or includes a set of battery electro-thermal constraints, such as exemplified in FIG. 2 for the example performance-lifetime classes PL1, PL2, PL3 and PL4, respectively.

Various examples of how to fuse multiple SoP values are further described in e.g. WO/2021/121673, WO/2021/121672, WO/2020/128068 and/or WO/2021/254620 by the same applicant, documents that are in their entirety incorporated herein by reference. As one example, a power-ability problem may be formulated as how to weight SoP values for different battery packs to obtain a single SoP value for the ESS as a whole, e.g.

$$SoP_{ESS} = \sum_{i=1}^{M} \alpha_i \cdot SoP_i,$$

where $\alpha_i$ is a weight coefficient. Various solutions to this problem may include e.g. an ideal or optimal (e.g. a theoretically maximum achievable solution) such as

$$SoP_{ESS} = \sum_{i=1}^{M} SoP_i.$$

A more conservative (fixed de-rating) solution may include

$$SoP_{ESS} = M \cdot \alpha \cdot \min(SoP_i),$$

i.e. to calculate the value $SoP_{ESS}$ based on the battery pack for which the SoP value is the lowest. Another conservative (gain-scheduled de-rating) may include

$$SoP_{ESS} = M \cdot \alpha(*) \cdot \min(SoP_i),$$

where the scaling-coefficient $\alpha(*)$ is found based on current operating conditions (such as current, temperature, SoC, etc.). A reactive solution may use feedback about actual current split to adapt $\alpha$), e.g.

$$SoP_{ESS} = f(\alpha_i(P_i), SoP_i),$$

such that the weighting of each SoP for each battery pack is made dependent on how much power the battery pack is currently receiving/providing. Other solutions may be predictive, and e.g. use model-based current split predictions, such as zero-order or e.g. full-order model-based solutions. To account for the envisaged possibility of using different performance-lifetime classes, the above-mentioned concepts may be generalized to e.g. define

$$SoP_{ESS,j} = \sum_{i=1}^{M} \alpha_i \cdot SoP_j^i,$$

$$SoP_{ESS,j} = M \cdot \alpha \cdot \min(SoP_{i,j}),$$

$$SoP_{ESS,j} = M \cdot \alpha(*) \cdot \min(SoP_{i,j}),$$

$$SoP_{ESS,j} = f(\alpha_i(P_i), SoP_{i,j}),$$

or similar. More generally, one may have that

$$SoP_{ESS,j} = f(\{SoP_{i,j'}\}, \theta),$$

or

$$SoP_{ESS} = g(\{SoP_{i,j'}\}, \theta)$$

where $f$ and $g$ are functions that mixes SoP values from the set of SoP values for different battery packs and performance-lifetime classes $\{SoP_{i,j}\}$ based on one or more parameters $\theta$ indicative of the current or predicted driving situation and/or the at least one internal and/or external state of the vehicle, where $\theta$ may for example include a predicted or current power-demand/requirement, temperature, SoH, SoC, etc.

The proposed introduction of different performance-lifetime classes and corresponding different sets of constraints enables higher flexibility and/or adaptability in vehicle power management, and allows to meet a wider range of applications and use-cases (such as harsh, high, moderate, mild, etc.). Such adaptations in e.g. performance levels can be made in real-time according to a given vehicle performance demand situation. Further, the envisaged adaptive SoP functionality enables to provide flexible initial offers to owners of the vehicles, e.g. a vehicle with different initial performance and lifetime variants/combinations from which the owner may chose during vehicle configuration at e.g. time of purchase, or similar. The envisaged adaptive SoP functionality also enables the use of various driving modes (e.g. mild, moderate, high, extreme, etc.) that can be selected by e.g. a driver of the vehicle during vehicle operation, in accordance with the given usage scenario as indicated via e.g. a human-machine interface (HMI) or dedicated button, or similar. In addition, the envisaged adaptive SoP functionality also enables various charging modes (slow, moderate, fast, ultra-fast, etc.), that can be selected by e.g. the driver via e.g. the HMI or a dedicated button. The envisaged solution also enables to provide e.g. an emergency power boost that may be selected by e.g. the driver during vehicle operation, and which may be useful to e.g. bring the vehicle to a safe state and/or position during an emergency situation.

As envisaged herein, in addition to a predicted usage scenario, SoP values may also be calculated according to one or more pre-determined (i.e., fixed) use-cases. For example, a vehicle control unit may select one of these fixed use-cases for a current customer vehicle application and then request the BMS to transmit SoP values accordingly. A vehicle control unit may choose an appropriate use-case from the given set of use-cases based on some a priori information about the customer vehicle application. This a priori information may be provided either based on stored information regarding e.g. vehicle type, customer type, contact type, or mission type. This information may be stored either on-board the vehicle (e.g. in storage 574) at the time of production or it may be stored/updated in the cloud 570 based on e.g. a customer's usage history.

In some examples, it is further envisaged that the potential impact on battery lifetime may be determined and displayed (via a suitable display provided e.g. in a driver's cabin of the vehicle) for the user-selected usage scenario, such that the user can make more battery health-conscious choices. A lifetime sensitivity to each performance-lifetime class may for example be determined either online based on one or more aging models or e.g. based on pre-determined look-up tables for selected use-cases.

As a further example, as envisaged herein, the different sets of battery electro-thermal constraints need not necessarily be predefined, but may be calculated dynamically, e.g. through a mapping function for given usage requirements. For example, if it is known that a particular power will be required for a particular length of time, an inverse problem may be solved to determine what constraints the battery (pack) need to be operated within while still being able to meet the required power-ability (SoP). Also in such a situation, the conventional restriction to only a single set of pre-defined calibration constraints is lifted, and more flexibility and adaptivity is provided as already discussed herein.

Generally herein, when referring to a "signal", this may be a real signal as communicated electronically, optically, magnetically, electromagnetically, mechanically, or similar, but may also refer to e.g. information being shared via a shared computer memory-space or similar. Most generally, a "signal" is here meant as a placeholder for information that is somehow shared between different entities, processes, modules, functionalities, and similar, independent of what exact form or means of implementation such a signal corresponds to.

Generally herein, to "determine a SoP for a particular set of constraints" may include solving a mathematical optimization problem, which may also take one or more other factors/restrictions/limitations into account. For example, for a given electro-thermal constraint set *S*, a mathematical optimization problem can be formulated to find the maximum magnitude of power for the given constraint set *S*. For example, a problem may be formulated as how to maximize power *P* or absolute power |*P*| over a particular time interval $t \in [t, t + t_h]$, where *t* is time and $t_h$ the length of the time interval (e.g. the time-horizon). The maximization/optimization may be subject to various constraints, such as electro-thermal dynamic constraints and other electro-thermal static constraints such as e.g. constraints on SoC, voltage, temperature, absolute max power, RMS power for lifetime, and/or an allowed over-utilization budget (i.e. an allowed utilization above static electro-thermal limit(s) as per lifetime target).

For example, the envisaged optimization problem may be formulated as

$$\max |P| \ \forall t \in [t, t + t_h],$$

subject to a set of electro-thermal dynamic constraints

$$\dot{x}_e = f_e(x_e, x_t, P),$$

$$\dot{x}_t = f_t(x_e, x_t, P),$$

$$V(t) = f_1(x_e, x_t, P),$$

$$T(t) = f_2(x_e, x_t, P),$$

where $x_e$ and $x_t$ is the evolution of battery electrical states (such as voltages and SoC) and temperature, respectively, as corresponding functions of current/power input *P*. Other electro-thermal static constraints may include e.g. a SoC constraint

$$SoC_{min} \leq SoC(t + t_h) \leq SoC_{max},$$

where $SoC_{min/max}$ is the lower and upper SoC-level, respectively; a voltage constraint

$$V_{min} \leq V(t + t_h) \leq V_{max},$$

where $V_{min/max}$ is the lower and upper voltage-level, respectively; a temperature constraint

$$T_{min} \leq T(t + t_h) \leq T_{max},$$

where $T_{min/max}$ is the lower and upper temperature-level, respectively; an absolute maximum power constraint

$$\alpha P_{min} \leq P(t + t_h) \leq \alpha P_{max},$$

where $P_{min/max}$ is the lower and upper power-level, respectively, and $\alpha$ a scaling factor; an RMS power constraint for lifetime

$$P_{rms} \leq P_{rms}^{lim} \ \ \forall t \in [T - T_{rms}, t + t_h],$$

where $P_{rms}^{lim}$ is a power RMS limit and $T_{rms}$ a time interval over such RMS is considered; and e.g. an allowed over-utilization budget

$$\int_{-\infty}^{t} \tau_{os}(\tau) \cdot P_{act}(\tau) d\tau \leq E_{os}^{lim},$$

where $E_{os}^{lim}$ is a limit on energy consumed under power overshoot, i.e. an accumulated energy limit under overshoot. In the above integral, $\tau_{os}(\tau)$ is a function that becomes one whenever $P_{act} > P_{max}$ and zero otherwise, i.e. such that contributions to the integral are only made when there is power overshoot. Through such a constraint, some overshoot may be allowed in the power but with some constraints on total energy consumed during the overshoot. The indicate lifetime targets and constraints may be derived using e.g. one or more aging models for the battery packs, and the constraint mathematical optimization problem may be solved using e.g. various nonlinear programming (NLP) methods or similar. In some cases, it is envisaged to also find closed-form analytical solutions depending on the exact type(s) of electro-thermal models and constraint sets. Other envisaged solutions include e.g. those based on heuristics (such as exhaustive search methods), or analytical solutions in some cases involving e.g. simple linear battery models and linear constraints.

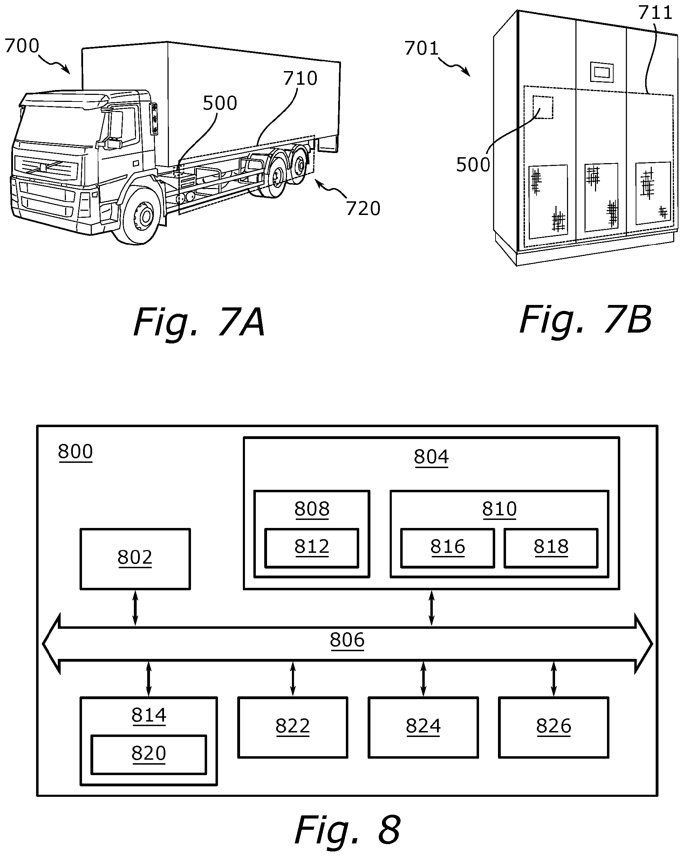

FIG. 7A schematically illustrates an example electric vehicle as envisaged herein, here exemplified by a cargo box-truck 700. The truck 700 includes an energy system 710 with a plurality of battery packs as envisaged herein, and the computer system 500 (used to implement e.g. one or both of the example solutions described with reference to FIGS. 3 and 4). The ESS 710 is for example used to provide power to an electric propulsion system 720 of the vehicle 700, including e.g. one or more electrical machines for providing torque at the wheels of the vehicle 700. The vehicle 700 of course only serves as one illustrative example of an electric vehicle, and electric vehicles as envisaged herein may take on many other forms. For example, such vehicles may include buses, tractors, vehicle combinations, semitrailers, pieces of heavy equipment such as wheel loaders, articulated haulers, or any type of vehicle or machine that are electric and includes an ESS, and which may benefit from the envisaged solution of managing power input/output by adaptive SoP functionality as described herein.

FIG. 7B schematically illustrates an example stationary BESS solution as envisaged herein, here in form of a battery bank 701 configured to deliver (or receive) energy to (or from) a power grid, as part of e.g. a backup- and/or ancillary service. The battery bank 701 includes an ESS 711 and the computer system 500 as described herein. The battery bank 701 may for example be installed as part of the power grid itself, and/or be provided as part of an industrial or residential building, or similar. In general, FIG. 7B and the power bank 701 serve to illustrate that the computer system 500, method 600 and overall solution as envisaged herein are not necessarily restricted only to electric vehicles, but may find use in any situation where there is an (B)ESS for which a usage scenario and/or at least one internal and/or external state can be determined, and which may benefit from not being limited only to a single set of predefined set of constraints in order to determine suitable SoP (i.e. power-abilities) values. An entity such as the battery bank 701 may for example include an ESS where one or more battery packs have been harvested from e.g. an electric vehicle, representing so-called "second use" wherein e.g. battery packs that are no longer considered useful in electric vehicles may still be used in other, less demanding applications, such as home or industrial energy storage solutions, off-grid solutions, grid solutions, and similar.

FIG. 8 is a schematic diagram of a computer system 800 for implementing examples disclosed herein. The computer system 800 is adapted to execute instructions from a computer-readable medium to perform these and/or any of the functions or processing described herein. The computer system 800 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 800 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 800 may comprise at least one computing device or electronic device capable of including firmware, hardware, and/or executing software instructions to implement the functionality described herein. The computer system 800 may include processing circuitry 802 (e.g., processing circuitry including one or more processor devices or control units), a memory 804, and a system bus 806. The computer system 800 may include at least one computing device having the processing circuitry 802. The system bus 806 provides an interface for system components including, but not limited to, the memory 804 and the processing circuitry 802. The processing circuitry 802 may include any number of hardware components for conducting data or signal processing or for executing computer code stored in memory 804. The processing circuitry 802 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 802 may further include computer executable code that controls operation of the programmable device.

The system bus 806 may be any of several types of bus structures that may further interconnect to a memory bus (with or without a memory controller), a peripheral bus, and/or a local bus using any of a variety of bus architectures. The memory 804 may be one or more devices for storing data and/or computer code for completing or facilitating methods described herein. The memory 804 may include database components, object code components, script components, or other types of information structure for supporting the various activities herein. Any distributed or local memory device may be utilized with the systems and methods of this description. The memory 804 may be communicably connected to the processing circuitry 802 (e.g., via a circuit or any other wired, wireless, or network connection) and may include computer code for executing one or more processes described herein. The memory 804 may include non-volatile memory 808 (e.g., read-only memory (ROM), erasable programmable read-only memory (EPROM), electrically erasable programmable read-only memory (EEPROM), etc.), and volatile memory 810 (e.g., random-access memory (RAM)), or any other medium which can be used to carry or store desired program code in the form of machine-executable instructions or data structures and which can be accessed by a computer or other machine with processing circuitry 802. A basic input/output system (BIOS) 812 may be stored in the non-volatile memory 808 and can include the basic routines that help to transfer information between elements within the computer system 800.

The computer system 800 may further include or be coupled to a non-transitory computer-readable storage medium such as the storage device 814, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 814 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hardcoded in circuitry to implement the functionality described herein in whole or in part. The modules may be stored in the storage device 814 and/or in the volatile memory 810, which may include an operating system 816 and/or one or more program modules 818. All or a portion of the examples disclosed herein may be implemented as a computer program 820 stored on a transitory or non-transitory computer-usable or computer-readable storage medium (e.g., single medium or multiple media), such as the storage device 814, which includes complex programming instructions (e.g., complex computer-readable program code) to cause the processing circuitry 802 to carry out actions described herein. Thus, the computer-readable program code of the computer program 820 can comprise software instructions for implementing the functionality of the examples described herein when executed by the processing circuitry 802. In some examples, the storage device 814 may be a computer program product (e.g., readable storage medium) storing the computer program 820 thereon, where at least a portion of a computer program 820 may be loadable (e.g., into a processor) for implementing the functionality of the examples described herein when executed by the processing circuitry 802. The processing circuitry 802 may serve as a controller or control system for the computer system 800 that is to implement the functionality described herein.

The computer system 800 may include an input device interface 822 configured to receive input and selections to be communicated to the computer system 800 when executing instructions, such as from a keyboard, mouse, touch-sensitive surface, etc. Such input devices may be connected to the processing circuitry 802 through the input device interface 822 coupled to the system bus 806 but can be connected through other interfaces, such as a parallel port, an Institute of Electrical and Electronic Engineers (IEEE) 1394 serial port, a Universal Serial Bus (USB) port, an IR interface, and the like. The computer system 800 may include an output device interface 824 configured to forward output, such as to a display, a video display unit (e.g., a liquid crystal display (LCD) or a cathode ray tube (CRT)). The computer system 800 may include a communications interface 826 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

The following is a non-exhaustive list of examples as envisaged herein:

Example 1: A computer system including processing circuitry configured to: i) obtain an indication of at least one of a) a current or predicted usage scenario for a battery energy storage system, ESS, and b) an internal and/or external state of an entity (such as e.g. an electric vehicle) including the ESS; ii) determine one or more state-of-power, SoP, values for each of a plurality of battery packs of the ESS; iii) determine one or more SoP values for the ESS as a whole by fusion of at least some of the SoP values for the battery packs determined in ii), and iv) determine a target SoP value for control of a charging and/or discharging of the ESS based on the one or more SoP values determined in iii), and to control the charging and/or discharging of the ESS based on said determined target SoP value, wherein the processing circuitry is further configured to select, from a plurality of different sets of constraints corresponding to different trade-offs between entity performance and battery lifetime, a particular set of constraints based on the indicated at least one of the current or predicted usage scenario and the internal and/or external state of the entity, and to use the particular set of constraints as part of the determining in at least one of ii), iii) and iv), wherein each set of constraints is or includes a set of battery electro-thermal constraints.

Example 2: The computer system of example 1, wherein the processing circuitry is further configured to: ii-a) as part of ii), determine at least one SoP value for each battery pack and for each of multiple sets of the constraints; iii-a) as part of iii), determine at least one SoP value for the ESS as a whole for each of multiple sets of constraints, and iv-a) as part of iv), determine the target SoP value used to control the charging and/or discharging of the ESS by selecting a SoP value for the ESS as a whole determined as part of iii-a) and corresponding to the particular set of constraints.

Example 3: The computer system of example 1, wherein the processing circuitry is further configured to: ii-a) as part of ii), determine the at least one SoP value for each battery pack based on the particular set of constraints.

Example 4: The computer system of example 3, wherein the determination in iii) and iv) does not include determining SoP values for multiple sets of constraints.

Example 5: The computer system of any one of the preceding examples, wherein each of ii) and iii) includes determining the SoP values also for each of a plurality of different time horizons.

Example 6: The computer system of any one of the preceding examples, wherein the battery electro-thermal constraints include constraints on at least battery temperature and voltage.

Example 7: The computer system of any one of the preceding examples, wherein the battery electro-thermal constraints include constraints on at least battery current as a function of battery state-of-charge, SoC, temperature and state-of-health, SoH.

Example 8: The computer system of any one of the preceding examples, wherein the battery electro-thermal constraints include constraints on at least one of an absolute max power constraint, a root-mean-square, RMS, power constraint for a battery lifetime, and an allowed battery over-utilization budget.

Example 9: The computer system of any one of the preceding examples, wherein the computer system is further configured to obtain the indication of the at least one of the current or predicted usage scenario and the internal and/or external state of the entity based on at least one of: - a historical usage pattern and power demand for the entity; - an instantaneous power demand defined by a user of the entity; - a pre-planned mission/assignment of the entity; and - real-time detection of power-demand for the entity.

Example 10: The computer system of any one of the preceding examples, wherein the processing circuitry is configured to perform the fusion in ii) based on the at least one of the current or predicted usage scenario and the internal and/or external state of the entity.

Example 11: The computer system of any one of the preceding examples, wherein the at least one internal and/or external state of the entity includes at least one of a battery state-of-health, SoH, and a state of one or more other components of the entity, such as brake health of the vehicle.

Example 12: The computer system of any one of the preceding examples, wherein the entity is an electric vehicle.

Example 13: The computer system of any one of the preceding examples, wherein the plurality of different sets of constraints are predefined.

Example 14: An electric vehicle including: - the computer system of any of examples 1 to 13, and - the energy storage system, ESS, including the plurality of battery packs.

Example 15: A computer-implemented method, including: - i) obtaining, by processing circuitry of a computer system, an indication of at least one of a) a current or predicted usage scenario and b) an internal and/or external state of an entity (such as e.g. an electric vehicle) including a battery energy storage system, ESS; ii) determining, by the processing circuitry, one or more state-of-power, SoP, values for each of a plurality of battery packs of the ESS; iii) determining, by the processing circuitry, one or more SoP values for the ESS as a whole by fusion of at least some of the SoP values for the battery packs determined in ii), and iv) determining, by the processing circuitry, a target SoP value for control of a charging and/or discharging of the ESS based on the one or more SoP values determined in iii), and to control the charging and/or discharging of the ESS based on said determined target SoP value, wherein the method further includes selecting, from a plurality of different sets of constraints corresponding to different trade-offs between vehicle performance and battery lifetime, a particular set of constraints based on the indicated at least one of the current or predicted usage scenario and the internal and/or external state of the entity, and using the particular set of constraints as part of the determining in at least one of ii), iii) and iv), wherein each set of constraints is or includes a set of battery electro-thermal constraints.

Example 16: A computer program including program code for performing, when executed by the processing circuitry, the method of example 15.

Example 17: A computer program product including program code for performing, when executed by the processing circuitry, the method of example 15.

Example 18: A non-transitory computer-readable storage medium including instructions, which when executed by the processing circuitry, cause the processing circuitry to perform the method of example 15.

Example 19: An entity including a battery energy storage system, ESS, including the computer system of any one of examples 1 to 13 and the ESS.

Example 20: The entity of example 19, wherein the entity is a stationary entity such as a battery bank for off-grid or grid usage.

**Claims**

1. A computer system (500, 800) comprising processing circuitry (510, 802) configured to:

   i) obtain an indication of at least one of a) a current or predicted usage scenario for a battery energy storage system, ESS, and b) an internal and/or external state of an entity, such as e.g. an electric vehicle, including the ESS;
   ii) determine one or more state-of-power, SoP, values for each of a plurality of battery packs of the ESS;

   iii) determine one or more SoP values for the ESS as a whole by fusion of at least some of the SoP values for the battery packs determined in ii), and
   iv) determine a target SoP value for control of a charging and/or discharging of the ESS based on the one or more SoP values determined in iii), and to control the charging and/or discharging of the ESS based on said determined target SoP value,

   wherein the processing circuitry is further configured to select, from a plurality of different sets of constraints corresponding to different trade-offs between entity performance and battery lifetime, a particular set of constraints based on the indicated at least one of the current or predicted usage scenario and the internal and/or external state of the entity, and to use the particular set of constraints as part of the determining in at least one of ii), iii) and iv), wherein each set of constraints is or includes a set of battery electro-thermal constraints.

2. The computer system of claim 1, wherein the processing circuitry is further configured to:

   ii-a) as part of ii), determine at least one SoP value for each battery pack and for each of multiple sets of the constraints;
   iii-a) as part of iii), determine at least one SoP value for the ESS as a whole for each of multiple sets of constraints, and
   iv-a) as part of iv), determine the target SoP value used to control the charging and/or discharging of the ESS by selecting a SoP value for the ESS as a whole determined as part of iii-a) and corresponding to the particular set of constraints.

3. The computer system of claim 1, wherein the processing circuitry is further configured to:
   ii-a) as part of ii), determine the at least one SoP value for each battery pack based on the particular set of constraints.

4. The computer system of claim 3, wherein the determination in iii) and iv) does not include determining SoP values for multiple sets of constraints.

5. The computer system of any one of the preceding claims, wherein each of ii) and iii) comprises determining the SoP values also for each of a plurality of different time horizons.

6. The computer system of any one of the preceding claims, wherein the battery electro-thermal constraints comprise constraints on at least battery temperature and voltage.

7. The computer system of any one of the preceding claims, wherein the battery electro-thermal constraints comprise constraints on at least battery current as a function of battery state-of-charge, SoC, temperature and state-of-health, SoH.

8. The computer system of any one of the preceding claims, wherein the battery electro-thermal constraints comprise constraints on at least one of an absolute max power constraint, a root-mean-square, RMS, power constraint for a battery lifetime, and an allowed battery over-utilization budget.

9. The computer system of any one of the preceding claims, wherein the computer system is further configured to obtain the indication of the at least one of the current or predicted usage scenario and the internal and/or external state of the entity based on at least one of:

    - a historical usage pattern and power demand for the entity;
    - an instantaneous power demand defined by a user of the entity;
    - a pre-planned mission or assignment of the entity; and
    - real-time detection of power-demand for the entity.

10. The computer system of any one of the preceding claims, wherein the processing circuitry is configured to perform the fusion in ii) based on the at least one of the current or predicted usage scenario and the internal and/or external state of the entity.

11. The computer system of any one of the preceding claims, wherein the at least one internal and/or external state of the entity comprises at least one of a battery state-of-health, SoH, and a state of one or more other components of the entity, such as brake health of the vehicle.

12. An electric vehicle (700) comprising:

    - the computer system (500, 800) of any of claims 1 to 11, and
    - the energy storage system, ESS, (710) comprising the plurality of battery packs.

13. A computer-implemented method (600), comprising:

    - i) obtaining (S610), by processing circuitry (510, 802) of a computer system (500, 800), an indication of at least one of a) a current or predicted usage scenario and b) an internal and/or external state of an entity, such as e.g. an electric vehicle, comprising a battery energy storage system, ESS;

ii) determining (S620), by the processing circuitry, one or more state-of-power, SoP, values for each of a plurality of battery packs of the ESS;
iii) determining (S630), by the processing circuitry, one or more SoP values for the ESS as a whole by fusion of at least some of the SoP values for the battery packs determined in ii), and
iv) determining (S640), by the processing circuitry, a target SoP value for control of a charging and/or discharging of the ESS based on the one or more SoP values determined in iii), and to control the charging and/or discharging of the ESS based on said determined target SoP value,

wherein the method further includes selecting (S605), from a plurality of different sets of constraints corresponding to different trade-offs between entity performance and battery lifetime, a particular set of constraints based on the indicated at least one of the current or predicted usage scenario and the internal and/or external state of the entity, and using the particular set of constraints as part of the determining in at least one of ii), iii) and iv), wherein each set of constraints is or includes a set of battery electro-thermal constraints.

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.

**Amended claims in accordance with Rule 137(2) EPC.**

1. A computer system (500, 800) comprising processing circuitry (510, 802) configured to:

    i) obtain an indication of at least one of a) a current or predicted power requirement for a battery energy storage system, ESS, and b) one or more internal battery states of the ESS and/or one or more states of one or more other components of an entity, such as e.g. an electric vehicle, in which the ESS is included;
    ii) determine one or more state-of-power, SoP, values for each of the plurality of battery packs of the ESS;
    iii) determine one or more SoP values for the ESS as a whole by fusion of at least some of the SoP values for the battery packs determined in ii), and

iv) determine a target SoP value for control of a charging and/or discharging of the ESS based on the one or more SoP values determined in iii), and to control the charging and/or discharging of the ESS based on said determined target SoP value,

wherein the processing circuitry is further configured to select, from a plurality of different sets of constraints corresponding to different trade-offs between entity performance and battery lifetime, a particular set of constraints based on said indication, and to use the particular set of constraints as part of the determining in at least one of ii), iii) and iv), wherein each set of constraints is or includes a set of battery electro-thermal constraints.

2. The computer system of claim 1, wherein the processing circuitry is further configured to:

ii-a) as part of ii), determine at least one SoP value for each battery pack and for each of multiple sets of the constraints;

iii-a) as part of iii), determine at least one SoP value for the ESS as a whole for each of multiple sets of constraints, and

iv-a) as part of iv), determine the target SoP value used to control the charging and/or discharging of the ESS by selecting a SoP value for the ESS as a whole determined as part of iii-a) and corresponding to the particular set of constraints.

3. The computer system of claim 1, wherein the processing circuitry is further configured to:

ii-a) as part of ii), determine the at least one SoP value for each battery pack based on the particular set of constraints.

4. The computer system of claim 3, wherein the determination in iii) and iv) does not include determining SoP values for multiple sets of constraints.

5. The computer system of any one of the preceding claims, wherein each of ii) and iii) comprises determining the SoP values also for each of a plurality of different time horizons.

6. The computer system of any one of the preceding claims, wherein the battery electro-thermal constraints comprise constraints on at least battery temperature and voltage.

7. The computer system of any one of the preceding claims, wherein the battery electro-thermal constraints comprise constraints on at least battery current as a function of battery state-of-charge, SoC, temperature and state-of-health, SoH.

8. The computer system of any one of the preceding claims, wherein the battery electro-thermal constraints comprise at least one of:

- limiting a power of the ESS to within lower and upper power-limits;
- limiting a root-mean-square, RMS, power of the ESS to at or below an RMS power limit, wherein said RMS is calculated over a time interval; and
- limiting an integral of power times a first factor over time to at or below an accumulated energy limit, wherein the first factor is one whenever the power exceeds an upper power limit and otherwise zero.

9. The computer system of any one of the preceding claims, wherein the computer system is further configured to obtain the indication of the at least one of the current or predicted usage scenario and the internal and/or external state of the entity based on at least one of:

- a historical usage pattern and power demand for the entity;
- an instantaneous power demand defined by a user of the entity;
- a pre-planned mission or assignment of the entity; and
- real-time detection of power-demand for the entity.

10. The computer system of any one of the preceding claims, wherein the processing circuitry is configured to perform the fusion in ii) based on the at least one of the current or predicted usage scenario and the internal and/or external state of the entity.

11. The computer system of any one of the preceding claims, wherein the at least one internal and/or external state of the entity comprises at least one of a battery state-of-health, SoH, and a state of one or more other components of the entity, such as brake health of the vehicle.

12. An electric vehicle (700) comprising:

- the computer system (500, 800) of any of claims 1 to 11, and
- the energy storage system, ESS, (710) comprising the plurality of battery packs.

13. A computer-implemented method (600), comprising:

- i) obtaining (S610), by processing circuitry (510, 802) of a computer system (500, 800), an indication of at least one of a) a current or predicted power requirement for a battery energy storage system, ESS, and b) one or more internal battery states of the ESS and/or one or more states of one or more other components of an entity, such as e.g. an electric vehicle, in which the ESS is included;

ii) determining (S620), by the processing circuitry, one or more state-of-power, SoP, values for each of the plurality of battery packs of the ESS;

iii) determining (S630), by the processing circuitry, one or more SoP values for the ESS as a whole by fusion of at least some of the SoP values for the battery packs determined in ii), and

iv) determining (S640), by the processing circuitry, a target SoP value for control of a charging and/or discharging of the ESS based on the one or more SoP values determined in iii), and to control the charging and/or discharging of the ESS based on said determined target SoP value,

wherein the method further includes selecting (S605), from a plurality of different sets of constraints corresponding to different trade-offs between entity performance and battery lifetime, a particular set of constraints based on said indication, and using the particular set of constraints as part of the determining in at least one of ii), iii) and iv), wherein each set of constraints is or includes a set of battery electrothermal constraints.

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.

# Fig. 1

# Fig. 2

**300**

**310**

**312-1**

**312-2**

⋮

**312-M**

$SoP_{i,1}^{cha/dch}$

$SoP_{i,2}^{cha/dch}$

⋮

$SoP_{i,N}^{cha/dch}$

320

**330**

$SoP_{ESS,1}^{cha/dch}$

$SoP_{ESS,2}^{cha/dch}$

⋮

$SoP_{ESS,N}^{cha/dch}$

340

**360**

362

**350**

# Fig. 3

**400**

**410**

**412-1**

**412-2**

⋮

**412-N**

464

$SoP_i^{cha/dch}$

420

**430**

463

$SoP_{ESS}^{cha/dch}$

440

462

**460**

**450**

400

# Fig. 4

**Fig. 5**

**Fig. 6**

**Fig. 7A**

**Fig. 7B**

**Fig. 8**

Europäisches
Patentamt

European
Patent Office

Office européen
des brevets

## EUROPEAN SEARCH REPORT

**Application Number**

EP 24 21 4195

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/128068 A1 (VOLVO TRUCK CORP [SE]) 25 June 2020 (2020-06-25) * different constraints in favour of balance or temperature; page 2, line 24 - line 39 * * page 5, line 16 - line 27 * * page 3, lines 23-24 * ----- | 1-15 | INV. B60L58/10 B60L58/16 B60L58/21 |
| A | WO 2021/254620 A1 (VOLVO TRUCK CORP [SE]) 23 December 2021 (2021-12-23) * the whole document * ----- | 1-15 | |
| A | EP 4 299 367 A1 (VOLVO TRUCK CORP [SE]) 3 January 2024 (2024-01-03) * the whole document * ----- | 1-15 | |
| A | US 2005/110498 A1 (PLETT GREGORY L [US]) 26 May 2005 (2005-05-26) * the whole document * ----- | 1-15 | |
| | | | TECHNICAL FIELDS SEARCHED (IPC) |
| | | | B60L G01R |

The present search report has been drawn up for all claims

| Place of search | Date of completion of the search | Examiner |
|---|---|---|
| The Hague | 21 May 2025 | Berkus, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 4195

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2025

| Patent document cited in search report | | Publication date | Patent family member(s) | | Publication date |
|---|---|---|---|---|---|
| WO 2020128068 | A1 | 25-06-2020 | CN | 113195291 A | 30-07-2021 |
| | | | CN | 114845901 A | 02-08-2022 |
| | | | CN | 114929504 A | 19-08-2022 |
| | | | EP | 3898313 A1 | 27-10-2021 |
| | | | EP | 4077020 A1 | 26-10-2022 |
| | | | EP | 4077021 A1 | 26-10-2022 |
| | | | US | 2022063444 A1 | 03-03-2022 |
| | | | US | 2023036362 A1 | 02-02-2023 |
| | | | US | 2023041052 A1 | 09-02-2023 |
| | | | WO | 2020128066 A1 | 25-06-2020 |
| | | | WO | 2020128068 A1 | 25-06-2020 |
| | | | WO | 2021121672 A1 | 24-06-2021 |
| | | | WO | 2021121673 A1 | 24-06-2021 |
| WO 2021254620 | A1 | 23-12-2021 | CN | 115702533 A | 14-02-2023 |
| | | | CN | 117856382 A | 09-04-2024 |
| | | | EP | 4169143 A1 | 26-04-2023 |
| | | | EP | 4394409 A2 | 03-07-2024 |
| | | | US | 2023219458 A1 | 13-07-2023 |
| | | | WO | 2021254620 A1 | 23-12-2021 |
| EP 4299367 | A1 | 03-01-2024 | EP | 4299367 A1 | 03-01-2024 |
| | | | US | 2024001800 A1 | 04-01-2024 |
| US 2005110498 | A1 | 26-05-2005 | BR | PI0416652 A | 16-01-2007 |
| | | | CA | 2547012 A1 | 02-06-2005 |
| | | | CN | 1883097 A | 20-12-2006 |
| | | | EP | 1692754 A1 | 23-08-2006 |
| | | | JP | 4722857 B2 | 13-07-2011 |
| | | | JP | 2007517190 A | 28-06-2007 |
| | | | KR | 20060107535 A | 13-10-2006 |
| | | | RU | 2336618 C2 | 20-10-2008 |
| | | | TW | I281298 B | 11-05-2007 |
| | | | US | 2005110498 A1 | 26-05-2005 |
| | | | US | 2008094035 A1 | 24-04-2008 |
| | | | US | 2010174500 A1 | 08-07-2010 |
| | | | WO | 2005050810 A1 | 02-06-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4299367 A1
- EP 4390793 A1
- WO 2021121673 A
- WO 2021121672 A
- WO 2020128068 A
- WO 2021254620 A